# EUROPEAN PATENT APPLICATION

(11) **EP 4 752 585 A1**
(43) Date of publication of application: **03.06.2026**
(21) Application number: 24216175.0
(22) Date of filing: 28.11.2024
(51) Int. Cl.: G01R 33/38, G01R 33/3815, G01R 33/389

(54) **SYSTEM AND METHOD FOR MONITORING PARAMETERS OF MAGNET ASSEMBLY OF MAGNETIC RESONANCE IMAGING SYSTEM**

(71) Applicant: Koninklijke Philips N.V., 5656 AE Eindhoven (NL)
(72) Inventor: FORTHMANN, Peter, Eindhoven (NL); VERNICKEL, Peter, Eindhoven (NL); LIPS, Oliver, 5656AG Eindhoven (NL)
(74) Representative: Philips Intellectual Property & Standards

(57) **Abstract**

A magnetic resonance imaging (MRI) system includes an outer vacuum container (OVC), a superconducting magnet housed within the OVC, and a plurality of sensors configured to monitor parameters of the superconducting magnet. The MRI system further includes a microcontroller disposed within the OVC and electrically connected to the plurality of sensors, and a communication interface configured to transmit data from the microcontroller to an external control system. The microcontroller is configured to multiplex signals from the plurality of sensors into a single data stream for transmission through the communication interface.

## Description

### FIELD

The inventive concepts generally relate to magnetic resonance imaging (MRI) systems, and more particularly, the inventive concepts relate to the monitoring of operational parameters of a magnet assembly housed within an outer vacuum container of MRI systems.

### BACKGROUND

Magnetic resonance imaging (MRI) systems have become an essential tool in medical diagnostics, providing detailed images of internal body structures without the use of ionizing radiation. At the heart of these systems is a powerful superconducting magnet that generates a strong, stable magnetic field. This magnet is typically housed within a cryostat, which includes an outer vacuum container (OVC) to maintain the extremely low temperatures required for superconductivity.

Ensuring the proper functioning and longevity of MRI magnets requires continuous monitoring of various parameters, including temperatures, pressures, voltages, and currents. This monitoring is crucial for maintaining magnet stability, detecting potential issues before they become critical, and optimizing system performance. As MRI technology advances, there is an increasing demand for more comprehensive and detailed monitoring capabilities.

Traditionally, the sensors used for monitoring these parameters are connected to external control systems through individual wires that pass through the cryostat's OVC. These connections are typically made using specialized, vacuum-tight connectors with a limited number of pins. As the number of monitored parameters grows, so does the complexity and cost associated with routing numerous signal lines through the cryostat.

Separately, the OVC of an MRI magnet is typically constructed of electrically conductive materials, such as stainless steel. While effective for maintaining the vacuum necessary for thermal insulation, these materials can interact with the changing magnetic fields produced by other components of the MRI system, such as gradient coils. This interaction can lead to the generation of eddy currents, which can introduce unwanted heating and forces within the magnet system.

### SUMMARY

According to an aspect of the inventive concepts, a magnetic resonance imaging (MRI) system is provided that includes an outer vacuum container (OVC), a superconducting magnet housed within the OVC, and a plurality of sensors configured to monitor parameters of the superconducting magnet. The MRI system further includes a microcontroller disposed within the OVC and electrically connected to the plurality of sensors, and a communication interface configured to transmit data from the microcontroller to an external control system. The microcontroller is configured to multiplex signals from the plurality of sensors into a single data stream for transmission through the communication interface.

The communication interface may include a wireless transmitter configured to transmit the single data stream wirelessly to the external control system. The wireless transmitter may be a Wi-Fi transmitter embedded in the microcontroller. The OVC may include at least a portion that is electromagnetically transparent to allow wireless transmission of the single data stream.

The communication interface may be configured to transmit the single data stream over power lines connected to the superconducting magnet.

The plurality of sensors may include at least one of temperature sensors, pressure sensors, voltage sensors, and current sensors.

The microcontroller may include an analog-to-digital converter configured to digitize analog signals from the plurality of sensors.

According to another aspect of the inventive concepts, a method of monitoring a magnetic resonance imaging (MRI) system is provided. The method includes receiving, by a microcontroller disposed within an outer vacuum container (OVC) of the MRI system, signals from a plurality of sensors configured to monitor parameters of a superconducting magnet. The method further includes multiplexing, by the microcontroller, the received signals into a single data stream, and transmitting the single data stream from the microcontroller to an external control system through a communication interface.

The method may further include digitizing, by the microcontroller, analog signals received from at least a portion of the plurality of sensors.

Transmitting the single data stream may include wirelessly transmitting the single data stream through a portion of the OVC that is electromagnetically transparent.

The method may further include powering the microcontroller using the power lines connected to the superconducting magnet.

According to yet another aspect of the inventive concepts, a magnetic resonance imaging (MRI) system is provided that includes an outer vacuum container (OVC) at least partially constructed of a material transparent to electromagnetic signals, a superconducting magnet housed within the OVC, and a plurality of sensors configured to monitor parameters of the superconducting magnet. The MRI system further includes a microcontroller disposed within the OVC and electrically connected to the plurality of sensors, and a wireless communication interface integrated with the microcontroller and configured to transmit data through the material transparent to electromagnetic signals to an external control system.

The microcontroller may include an analog-to-digital converter configured to digitize analog signals from the plurality of sensors. The microcontroller may be configured to multiplex the digitized signals from the plurality of sensors into a single data stream for wireless transmission. The wireless communication interface may be a Wi-Fi transmitter configured to transmit the single data stream using a Wi-Fi protocol.

The microcontroller is configured to sample the plurality of sensors at predetermined intervals and transmit updated parameter data to the external control system.

### BRIEF DESCRIPTION OF THE DRAWINGS

The above and other aspects and features of the inventive concepts will become readily apparent from the detailed description that follows, with reference to the accompanying drawings, in which:
FIG. 1 is a schematic diagram of a magnetic resonance imaging (MRI) system;
FIG. 2 is a schematic diagram of the magnet assembly of an MRI system;
FIG. 3 is a simplified block diagram of a magnet assembly of an MRI system according to embodiments of the inventive concepts; and
FIG. 4 is a simplified block diagram of a magnet assembly of an MRI system according to other embodiments of the inventive concepts

### DETAILED DESCRIPTION

In the following detailed description, for purposes of explanation and not limitation, representative embodiments disclosing specific details are set forth in order to provide a thorough understanding of the present teachings. However, it will be apparent to one having ordinary skill in the art having had the benefit of the present disclosure that other embodiments according to the present teachings that depart from the specific details disclosed herein remain within the scope of the appended claims. Moreover, descriptions of well-known apparatuses and methods may be omitted to avoid obscuring the description of the example embodiments. Such methods and apparatuses are clearly within the scope of the present teachings. Further, throughout the drawings, like reference numbers refer to the same or similar elements. Features described in relation to a system, may be implemented in a method, in a corresponding manner.

The terminology used herein is for purposes of describing particular embodiments only, and is not intended to be limiting. The defined terms are in addition to the technical and scientific meanings of the defined terms as commonly understood and accepted in the technical field of the present teachings. As used in the specification and appended claims, the terms 'a', 'an' and 'the' include both singular and plural referents, unless the context clearly dictates otherwise. Thus, for example, `a device' includes one device and plural devices. Further, for example, when one element is described as being "connected to" another element, the one element may be directly connected to the other element, or indirectly connected to the other element in an operative manner.

Separately, as is traditional in the field of the inventive concepts, embodiments may be described, and illustrated in the drawings, in terms of functional blocks, units and/or modules. Those skilled in the art will appreciate that these blocks, units and/or modules are physically implemented by electronic (or optical) circuits such as logic circuits, discrete components, microprocessors, hard-wired circuits, memory elements, wiring connections, and the like, which may be formed using semiconductor-based fabrication techniques or other manufacturing technologies. In the case of the blocks, in the absence of an indication to the contrary, the units and/or modules being implemented by microprocessors or similar may be programmed using software (e.g., microcode) to perform various functions discussed herein and may optionally be driven by firmware and/or software. Alternatively, each block, unit and/or module may be implemented by dedicated hardware, or as a combination of dedicated hardware to perform some functions and a processor (e.g., one or more programmed microprocessors and associated circuitry) to perform other functions. Also, each block, unit and/or module of the example embodiments may be physically separated into two or more interacting and discrete blocks, units and/or modules without departing from the scope of the example embodiments. Conversely, the blocks, units and/or modules of the example embodiments may be physically combined into more complex blocks, units and/or modules without departing from the scope of the example embodiments.

As MRI technology continues to evolve, there is a growing need for more sophisticated monitoring capabilities, improved signal management, and reduced interference from eddy currents. These challenges call for innovative approaches to magnet design, sensor integration, and data transmission that can enhance the performance, reliability, and efficiency of MRI systems.

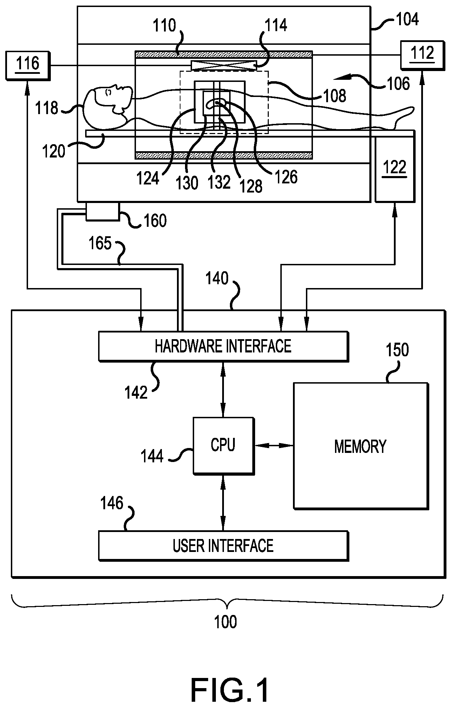

FIG. 1 shows an example of a magnetic resonance imaging (MRI) system 100 having a magnet 104. The magnet 104 may be a superconducting cylindrical type magnet 104 with a bore 106 extending therethrough. The use of different types of magnets is also possible. For instance, it is also possible to use both a split cylindrical magnet and a so-called open magnet. A split cylindrical magnet is similar to a standard cylindrical magnet, except that the cryostat has been split into two sections to allow access to the iso-plane of the magnet, such magnets may for instance be used in conjunction with charged particle beam therapy. An open magnet has two magnet sections, one above the other with a space in-between that is large enough to receive a subject. In the embodiments that follow, the magnet 104 is assumed to be a cylindrical magnet, although the inventive concepts are not limited in this fashion.

Inside a cryostat of the magnet 104, there is a collection of superconducting coils. As will be described in greater detail below, the coils within the magnet 104 are housed within a container referred to herein as an Outer Vacuum Container (OVC).

Within the bore 106 of the cylindrical magnet 104 there is an imaging zone 108 where the magnetic field is sufficiently strong and uniform to perform magnetic resonance imaging.

Within the bore 106 of the magnet there may also be a set of magnetic field gradient coils 110 which is used for acquisition of magnetic resonance data to spatially encode magnetic spins within the imaging zone 108 of the magnet 104. The magnetic field gradient coils 110 are connected to a magnetic field gradient coil power supply 112. The magnetic field gradient coils 110 as depicted in FIG. 1 is intended to be representative. That is, the magnetic field gradient coils 110 may contain three separate sets of coils for spatially encoding in three orthogonal spatial directions. The current supplied to the magnetic field gradient coils 110 may be controlled as a function of time and may be ramped or pulsed.

In the example of FIG. 1, adjacent to the imaging zone 108 is a radio-frequency coil 114 for manipulating the orientations of magnetic spins within the imaging zone 108 and for receiving radio transmissions from spins also within the imaging zone 108. The radio frequency antenna may contain multiple coil elements. The radio-frequency coil 114 is connected to a radio frequency transceiver 116. The radio-frequency coil 114 and radio frequency transceiver 116 may be replaced by separate transmit and receive coils and a separate transmitter and receiver. It is understood that the radio-frequency coil 114 and the radio frequency transceiver 116 as depicted in FIG. 1 and described here are representative. The radio-frequency coil 114 is intended to also represent a dedicated transmit antenna and a dedicated receive antenna. Likewise, the transceiver 116 may also represent a separate transmitter and receivers. The radio-frequency coil 114 may also have multiple receive/transmit elements and the radio frequency transceiver 116 may have multiple receive/transmit channels.

Within the bore 106 of the magnet 104 there is a subject support 120 which is attached to an optional actuator 122 that is able to move the subject support 120 and the subject 118 through the imaging zone 108. Within the imaging zone 108 there can be seen a three-dimensional volume 124. The three-dimensional volume 124 corresponds with the volume imaged by a survey image. There is an internal structure 126 within the subject 118. A target region 128 has been identified within the internal structure 126. This may be used to identify and place a predefined region of interest 130 that corresponds to the coordinates or location of the target region 128 and/or the location of the internal structure 126. The block 132 denotes the location of a subsequent follow-up magnetic resonance image.

The transceiver 116, the magnetic field gradient coil power supply 112 and the actuator 122 are all seen as being connected to a hardware interface 142 of computer system 140. The computer system 140 further comprises a processor (CPU) 144 connected to the hardware interface 142. The hardware interface 142 enables the processor 144 to send and receive data and commands to the magnetic resonance imaging system 100. The computer system 140 may further include a user interface 146, and computer memory 150 that are in communication with the processor 144.

As discussed previously, proper functioning and longevity of magnets 104 requires continuous monitoring of various parameters, including temperatures, pressures, voltages, and currents. This is conventionally carried out using sensors for monitoring these parameters. Referring to FIG. 1, the sensors are connected to external control systems through individual wires that pass through the cryostat's OVC into a turret 160, where they are electrically connected to the hardware interface 142 by a cabling system 165. These connections are typically made using specialized, vacuum-tight connectors with a limited number of pins. As the number of monitored parameters grows, so does the complexity and cost associated with routing numerous signal lines through the cryostat.

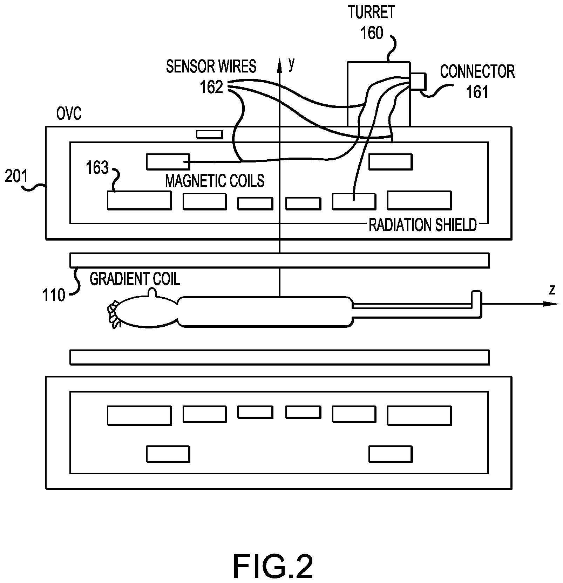

Attention is now directed to FIG. 2 for further discussion of the sensor wire configuration within a conventional OVC.

FIG. 2 illustrates a simplified diagram of magnetic coils surrounded by a radiation shield within an OVC 201. Also shown in FIG. 2 is the gradient coil 110 discussed above in connection with FIG. 1. A plurality of wires 162 extend from sensors (not shown) dispersed throughout the magnetic assembly. Although three sensor wires 162 are shown in FIG. 2, in actual practice dozens if not hundreds of sensor wires may be provided. Note here that each sensor may in some case include both a signaling wire and a power wire.

As shown, the sensor wires 162 extend through the OVC 201 (and radiation shield, if necessary) into a turret 160 mounted on the outside of the OVC 201. That is, monitoring many parameters of the magnet requires many connections that have to be routed through the cryostat. This is usually done through expensive filtered, vacuum-tight connectors with limited pin count. As described next, the inventive concepts are directed to a system configured to increase the number of signals that can be measured with a small number or even zero signal pins.

The inventive concepts add a microcontroller inside the magnet. The monitoring signal lines that are usually fed through the vacuum connector are routed to ADC input pins of the microcontroller, where they are digitized. Since the signals to be monitored (pressures, temperatures) change very slowly compared to the clock frequency of the microcontroller, any number of inputs can be comfortably multiplexed and serialized onto a single data line. That way, previously N (a relatively large integer) signals can be routed out of the magnet with a handful of pins (two pins for power supply, one or two pins for serial, potentially one or two for control purposes).

The microcontroller board (or two or more for redundancy) can be anchored to the OVC, so that it is kept at room temperature. Other locations may be possible, too. Experiments have shown that a microcontroller can run at elevated cryogenic temperatures, so operation close to the magnet radiation shield may well be possible.

In the case of a (partially) transparent cryostat, signal lines may not even be necessary, as virtually all microprocessor boards nowadays have WiFi capability. This would likely be the most convenient way to communicate.

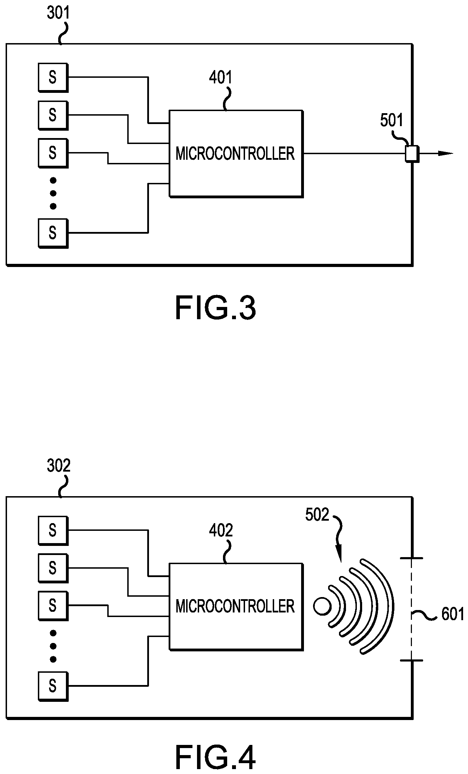

FIG. 3 is a highly simplified schematic view of an MRI system including an OVC 301 according to embodiments of the inventive concepts. For simplicity of the figure, the superconducting magnet, radiation shield and other components of the magnetic assembly housed within the OVC 301 are not shown.

Referring to FIG. 3, a plurality of sensors 3 are contained within the OVC 301. As discussed above, these sensors monitor numerous operating parameters of the magnetic assembly. As examples, the sensors S may include temperature sensors, pressure sensors, voltage sensors, and current sensors.

As shown, microcontroller 401 is disposed within the OVC 301 and electrically connected to the plurality of sensors S. The microcontroller 401 may be mounted to a wall of the OVC, or to any other suitable component within the OVC 301. The monitoring signal lines are routed to ADC input pins of the microcontroller, where they may be digitized and multiplexed into a single data stream for transmission through a communication interface. As mentioned previously, since the signals to be monitored (pressures, temperatures) change very slowly compared to the clock frequency of the microcontroller, any number of inputs can be comfortably multiplexed and serialized onto a single data line. In some embodiments, the microcontroller 401 is configured to sample the plurality of sensors S at predetermined intervals and transmit updated parameter data to the external control system.

Still referring to FIG. 3, the communication interface 501 is provided. The communication interface 501 is configured to transmit data from the microcontroller 401 to an external control system (such as the computer system 140 shown and described above in connection with FIG. 1). The communication interface may facilitate the transfer of sensor data, allowing for remote monitoring and control of the MRI system. In the example of FIG. 3, the communication interface is a wired connection. In some embodiments, the single data stream is transmitted over power lines connected to the superconducting magnet.

FIG. 4 is a highly simplified schematic view of an MRI system including an OVC 302 according to embodiments of the inventive concepts. As before, for simplicity of the figure, the superconducting magnet, radiation shield and other components of the magnetic assembly housed within the OVC 302 are not shown.

Referring to FIG. 4, a plurality of sensors 3 are contained within the OVC 302. As discussed above, these sensors monitor numerous operating parameters of the magnetic assembly. As examples, the sensors S may include temperature sensors, pressure sensors, voltage sensors, and current sensors.

As shown, microcontroller 402 is disposed within the OVC 302 and electrically connected to the plurality of sensors S. The microcontroller 402 may be mounted to a wall of the OVC 302, or to any other suitable component within the OVC 302. The monitoring signal lines are routed to ADC input pins of the microcontroller 402, where they may be digitized and multiplexed into a single data stream for transmission through a communication interface. As mentioned previously, since the signals to be monitored (pressures, temperatures) change very slowly compared to the clock frequency of the microcontroller, any number of inputs can be comfortably multiplexed and serialized onto a single data line. In some embodiments, the microcontroller 402 is configured to sample the plurality of sensors S at predetermined intervals and transmit updated parameter data to the external control system.

Still referring to FIG. 4, the communication interface 502 is provided. The communication interface 502 is configured to transmit data from the microcontroller 402 to an external control system (such as the computer system 140 shown and described above in connection with FIG. 1). The communication interface 502 may facilitate the transfer of sensor data, allowing for remote monitoring and control of the MRI system. In the example of FIG. 4, the communication interface is a wireless connection.

The OVC may comprise at least a portion 601 that is electromagnetically transparent. This feature may allow for the wireless transmission of a single data stream from the microcontroller 402 to the external control system. The electromagnetic transparency of the OVC may facilitate the passage of wireless signals, such as those used in Wi-Fi communication, through the OVC without significant attenuation or distortion.

In some embodiments, the communication interface 502 includes a wireless transmitter embedded within the microcontroller 402. The wireless transmitter is a Wi-Fi transmitter.

In some embodiments, the OVC 302 is constructed of a material that is transparent to electromagnetic signals. For example, the OVC 302 may be made of a plastic material instead of traditional stainless steel. The use of a plastic material for the OVC 302 may reduce the generation of eddy currents within the OVC. Eddy currents, which are circulating currents induced in a conductor when it is exposed to a changing magnetic field, can generate heat and potentially interfere with the operation of the MRI system. By using a material that is less conductive, such as plastic, the generation of eddy currents may be minimized, potentially improving the performance and efficiency of the MRI system.

It is understood that one or more of the aforementioned embodiments of the invention may be combined as long as the combined embodiments are not mutually exclusive. While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims. While representative embodiments are disclosed herein, one of ordinary skill in the art will appreciate that many variations that are in accordance with the present teachings are possible and remain within the scope of the appended claim set. The invention therefore is not to be restricted except within the scope of the appended claims.

## Claims

1. A magnetic resonance imaging, MRI, system, comprising:
an outer vacuum container, OVC;
a superconducting magnet housed within the OVC;
a plurality of sensors configured to monitor parameters of the superconducting magnet;
a microcontroller disposed within the OVC and electrically connected to the plurality of sensors; and
a communication interface configured to transmit data from the microcontroller to an external control system,
wherein the microcontroller is configured to multiplex signals from the plurality of sensors into a single data stream for transmission through the communication interface.

2. The MRI system of claim 1, wherein the communication interface comprises a wireless transmitter configured to transmit the single data stream wirelessly to the external control system, wherein optionally, the wireless transmitter is a Wi-Fi transmitter.

3. The MRI system of claim 1 or 2, wherein the OVC comprises at least a portion that is electromagnetically transparent to allow wireless transmission of the single data stream.

4. The MRI system of any one of claims 1 to 3, wherein the communication interface is configured to transmit the single data stream over power lines connected to the superconducting magnet.

5. A magnetic resonance imaging, MRI, system, comprising:
an outer vacuum container, OVC, at least partially constructed of a material transparent to electromagnetic signals;
a superconducting magnet housed within the OVC;
a plurality of sensors configured to monitor parameters of the superconducting magnet;
a microcontroller disposed within the OVC and electrically connected to the plurality of sensors; and
a wireless communication interface integrated with the microcontroller and configured to transmit data through the material transparent to electromagnetic signals to an external control system.

6. The MRI system of any one of claims 1 to 5, wherein the microcontroller comprises an analog-to-digital converter configured to digitize analog signals from the plurality of sensors.

7. The MRI system of claim 6, wherein the microcontroller is configured to multiplex the digitized signals from the plurality of sensors into a single data stream for wireless transmission.

8. The MRI system of claim 7, wherein the wireless communication interface is a Wi-Fi transmitter configured to transmit the single data stream using a Wi-Fi protocol.

9. The MRI system of any one of claims 1 to 8, wherein the microcontroller is configured to sample the plurality of sensors at predetermined intervals and transmit updated parameter data to the external control system.

10. A method of monitoring a magnetic resonance imaging, MRI, system, comprising:
receiving, by a microcontroller disposed within an outer vacuum container, OVC, of the MRI system, signals from a plurality of sensors configured to monitor parameters of a superconducting magnet;
multiplexing, by the microcontroller, the received signals into a single data stream; and
transmitting the single data stream from the microcontroller to an external control system through a communication interface.

11. The method of claim 10, further comprising digitizing, by the microcontroller, analog signals received from at least a portion of the plurality of sensors.

12. The method of claim 10 or 11, wherein transmitting the single data stream comprises wirelessly transmitting the single data stream through a portion of the OVC that is electromagnetically transparent.

13. The method of claim 12, wherein wirelessly transmitting the single data stream comprises transmitting the single data stream using a Wi-Fi protocol.

14. The method of any one of claims 10 to 13, wherein transmitting the single data stream comprises transmitting the single data stream over power lines connected to the superconducting magnet, optionally further comprising powering the microcontroller using the power lines connected to the superconducting magnet.

15. The MRI system of any one of claims 1 to 9 or the method according to any one of claims 10 to 14, wherein the plurality of sensors comprises at least one of temperature sensors, pressure sensors, voltage sensors, and current sensors.
